# EUROPEAN PATENT APPLICATION

(11) **EP 4 047 661 A2**
(43) Date of publication of application: **24.08.2022**
(21) Application number: 22156043.6
(22) Date of filing: 10.02.2022
(51) Int. Cl.: H01L 27/32, G06F 3/041, G06V 40/13, H01L 51/50

(54) **SENSOR-EMBEDDED DISPLAY PANEL AND ELECTRONIC DEVICE**

(30) Priority: 17.02.2021 KR 20210021474
(71) Applicant: Samsung Electronics Co., Ltd., Gyeonggi-do, 16677 (KR)
(72) Inventor: HEO, Chul Joon, Dongrae-gu (KR); PARK, Kyung Bae, Hwaseong-si (KR); YUN, Sung Young, Suwon-si (KR); CHOI, Taejin, Suwon-si (KR); FANG, Feifei, Suwon-si (KR); SIM, Myungsun, Suwon-si (KR); LEE, Sung Hun, Hwaseong-si (KR)
(74) Representative: Elkington and Fife LLP

(57) **Abstract**

A sensor-embedded display panel includes a substrate, first, second, and third light emitting elements on the substrate, the first, second, and third light emitting elements including separate, respective light emitting layers, and a light absorbing layer on the substrate, the light absorbing layer being in parallel with the light emitting layer along the surface direction of the substrate, wherein the first, second, and third light emitting elements and the light absorption sensor include a first common auxiliary layer that is continuously disposed on the light emitting layers and the light absorbing layer, and a common electrode on the first common auxiliary layer and configured to apply a common voltage to the first, second, and third light emitting elements and the light absorption sensor, and the light absorption sensor includes an n-type semiconductor layer between the light absorbing layer and the first common auxiliary layer and including an n-type semiconductor.

## Description

### FIELD OF THE INVENTION

Example embodiments of the inventive concepts are directed to sensor-embedded display panels and electronic devices.

### BACKGROUND OF THE INVENTION

Recently, there is an increasing demand for a display device implementing a biometric recognition technology that authenticates the person by extracting specific biometric information or behavioral characteristic information of a person with an automated device centering on finance, healthcare, and mobile. Accordingly, research is being conducted on a display device including a sensor capable of biometric recognition.

### SUMMARY OF THE INVENTION

Such a sensor capable of biometric recognition may be disposed under the display panel or may be separately manufactured as a separate module and mounted outside the display device. However, when the sensor is disposed under the display panel, the object should be recognized through the display panel, various films, and/or parts, and thus performance may be degraded. When the sensor is separately manufactured and mounted as a separate module, there are limitations in terms of design and usability.

Some example embodiments provide a sensor-embedded display panel including a sensor that is integrated with the display panel to improve performance.

Some example embodiments provide an electronic device including the sensor-embedded display panel.

According to some example embodiments, a sensor-embedded display panel may include a substrate; first, second, and third light emitting elements on the substrate and including separate, respective light emitting layers; and a light absorption sensor on the substrate and including a light absorbing layer, the light absorbing layer being in parallel with the light emitting layer along a surface direction of the substrate, wherein the first, second, and third light emitting elements and the light absorption sensor include a first common auxiliary layer that is continuously disposed on the separate, respective light emitting layers and the light absorbing layer, and a common electrode disposed on the first common auxiliary layer and configured to apply a common voltage to the first, second, and third light emitting elements and the light absorption sensor, and the light absorption sensor includes an n-type semiconductor layer between the light absorbing layer and the first common auxiliary layer, the n-type semiconductor layer including an n-type semiconductor.

The light absorption sensor may be configured to absorb light emitted from at least one of the first, second or third light emitting elements and then reflected by a recognition target and convert the absorbed light into an electrical signal.

The light absorbing layer may be configured to absorb light in a red wavelength spectrum, a green wavelength spectrum, a blue wavelength spectrum, or any combination thereof.

The light absorbing layer may include a p-type semiconductor.

The light absorbing layer may further include an n-type semiconductor, and the n-type semiconductor of the light absorbing layer may be a same n-type semiconductor as the n-type semiconductor of the light absorbing layer, or a different n-type semiconductor from the n-type semiconductor of the n-type semiconductor layer.

The light absorption sensor may further include a p-type semiconductor layer under the light absorbing layer and including a p-type semiconductor, and the p-type semiconductor of the p-type semiconductor layer may be a same p-type semiconductor as the p-type semiconductor of the light absorbing layer, or a different p-type semiconductor from the p-type semiconductor of the light absorbing layer.

The n-type semiconductor layer may have a LUMO energy level of about 3.3 eV to about 5.5 eV.

The LUMO energy level of the first common auxiliary layer may be between the LUMO energy level of each light-emitting layer of the separate, respective light emitting layers and a work function of the common electrode.

A LUMO energy level of the first common auxiliary layer may be shallower than a LUMO energy level of the light absorbing layer and a work function of the common electrode, respectively.

The first, second, and third light emitting elements and the light absorption sensor may further include a second common auxiliary layer extending continuously under the separate, respective light emitting layers and the light absorbing layer.

The first, second, and third light emitting elements may each independently be configured to emit one light selected from a red wavelength spectrum, a green wavelength spectrum, a blue wavelength spectrum, or any combination thereof, and the light absorbing layer may be configured to absorb light of the same wavelength spectrum as the light emitted from at least one light emitting element of the first, second, and third light emitting elements.

The sensor-embedded display panel may include a display area configured to display a color and a non-display area excluding the display area, and the light absorption sensor may be in the non-display area.

The display area may include a first subpixel configured to emit light in a red wavelength spectrum, the first subpixel including the first light emitting element, a second subpixel configured to emit light in a green wavelength spectrum, the second subpixel including the second light emitting element, and a third subpixel configured to emit light in a blue wavelength spectrum, the third subpixel including the third light emitting element, and the light absorption sensor may be between at least two of the first subpixel, the second subpixel, or the third subpixel.

Each light emitting element of the first, second, and third light emitting elements may be configured to emit light belonging to a visible wavelength spectrum, and the sensor-embedded display panel may further include a fourth light emitting element configured to emit light in an infrared wavelength spectrum.

The light absorption sensor may be configured to absorb light in the infrared wavelength spectrum.

The light absorbing layer may include an organic material.

The separate, respective light emitting layers may each include an organic light emitter, a quantum dot, perovskite, or any combination thereof.

According to some example embodiments, a sensor-embedded display panel may include a display area configured to display a color and a non-display area excluding the display area, wherein the display area includes a first subpixel configured to display a first color and including a first light emitting element, a second subpixel configured to display a second color and including a second light emitting element, and a third subpixel configured to display a third color and including a third light emitting element, the non-display area includes a light absorption sensor between at least two of the first subpixel, the second subpixel, or the third subpixel, the first light emitting element, the second light emitting element, the third light emitting element, and the light absorption sensor share a common electrode configured to apply a common voltage to the first light emitting element, the second light emitting element, the third light emitting element, and the light absorption sensor, and the light absorption sensor includes a light absorbing layer including a first p-type semiconductor and a first n-type semiconductor forming a pn junction and configured to absorb light reflected by a recognition target and to convert the absorbed light into an electrical signal, and an n-type semiconductor layer between the light absorbing layer and the common electrode and including a second n-type semiconductor, the second n-type semiconductor being a same n-type semiconductor as the first n-type semiconductor, or a different n-type semiconductor from the first n-type semiconductor.

The first light emitting element, the second light emitting element, the third light emitting element, and the light absorption sensor may share a first common auxiliary layer under the common electrode, and a LUMO energy level of the first common auxiliary layer may be shallower than a LUMO energy level of the light absorbing layer and a work function of the common electrode, respectively.

The first light emitting element, the second light emitting element, the third light emitting element, and the light absorption sensor may share a second common auxiliary layer facing the first common auxiliary layer.

The light absorption sensor may include a p-type semiconductor layer between the light absorbing layer and the second common auxiliary layer and including a second p-type semiconductor that is a same p-type semiconductor as the first p-type semiconductor, or a different p-type semiconductor from the first p-type semiconductor.

The sensor-embedded display panel may further include a fourth subpixel adjacent to at least one of the first subpixel, the second subpixel, or the third subpixel, and the fourth subpixel may include a fourth light emitting element configured to emit light in an infrared wavelength spectrum.

According to some example embodiments, an electronic device including the sensor-embedded display panel is provided.

Due to integration with the display panel, a high-performance sensor may be implemented while improving design and usability.

### BRIEF DESCRIPTION OF THE DRAWINGS

FIG. 1 is a plan view illustrating an example of a sensor-embedded display panel according to some example embodiments,
FIG. 2 is a cross-sectional view illustrating an example of a sensor-embedded display panel according to some example embodiments,
FIG. 3 is a cross-sectional view illustrating another example of a sensor-embedded display panel according to some example embodiments,
FIG. 4 is a schematic view illustrating an example of a smart phone as an electronic device according to some example embodiments,
FIG. 5 is a schematic view illustrating an example of a configuration view of an electronic device according to some example embodiments, and
FIG. 6 is a graph showing external quantum efficiency (EQE) according to the wavelength of the light absorption sensor according to Examples 1 and 2 and Comparative Example 1.

### DETAILED DESCRIPTION OF THE EMBODIMENTS

Hereinafter, example embodiments will be described in detail so that a person skilled in the art would understand the same. However, a structure that is actually applied may be implemented in various different forms and is not limited to the example embodiments described herein.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present.

It will further be understood that when an element is referred to as being "on" another element, it may be above or beneath or adjacent (e.g., horizontally adjacent) to the other element.

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Elements and/or properties thereof (e.g., structures, surfaces, directions, or the like) that are "substantially perpendicular" with regard to other elements and/or properties thereof will be understood to be "perpendicular" with regard to the other elements and/or properties thereof within manufacturing tolerances and/or material tolerances and/or have a deviation in magnitude and/or angle from "perpendicular," or the like with regard to the other elements and/or properties thereof that is equal to or less than 10% (e.g., a. tolerance of ±10%).

Elements and/or properties thereof (e.g., structures, surfaces, directions, or the like) that are "substantially parallel" with regard to other elements and/or properties thereof will be understood to be "parallel" with regard to the other elements and/or properties thereof within manufacturing tolerances and/or material tolerances and/or have a deviation in magnitude and/or angle from "parallel," or the like with regard to the other elements and/or properties thereof that is equal to or less than 10% (e.g., a. tolerance of ±10%).

Elements and/or properties thereof (e.g., structures, surfaces, directions, or the like) that are "substantially coplanar" with regard to other elements and/or properties thereof will be understood to be "coplanar" with regard to the other elements and/or properties thereof within manufacturing tolerances and/or material tolerances and/or have a deviation in magnitude and/or angle from "coplanar," or the like with regard to the other elements and/or properties thereof that is equal to or less than 10% (e.g., a. tolerance of ±10%).

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same.

It will be understood that elements and/or properties thereof described herein as being the "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

In the drawings, parts having no relationship with the description are omitted for clarity of the embodiments, and the same or similar constituent elements are indicated by the same reference numeral throughout the specification.

Hereinafter, the terms "lower" and "upper" are used for better understanding and ease of description, but do not limit the location relationship.

As used herein, when a definition is not otherwise provided, "substituted" refers to replacement of hydrogen of a compound by a substituent selected from a halogen, a hydroxy group, a nitro group, a cyano group, an amino group, an azido group, an amidino group, a hydrazino group, a hydrazono group, a carbonyl group, a carbamyl group, a thiol group, an ester group, a carboxyl group or a salt thereof, a sulfonic acid group or a salt thereof, a phosphoric acid or a salt thereof, a C1 to C30 alkyl group, a C2 to C30 alkenyl group, a C2 to C30 alkynyl group, a C6 to C30 aryl group, a C7 to C30 arylalkyl group, a C1 to C30 alkoxy group, a C1 to C20 heteroalkyl group, a C3 to C20 heterocyclic group, a C3 to C20 heteroarylalkyl group, a C3 to C30 cycloalkyl group, a C3 to C15 cycloalkenyl group, a C6 to C15 cycloalkynyl group, a C3 to C30 heterocycloalkyl group, and any combination thereof.

As used herein, when a definition is not otherwise provided, "hetero" refers to one including 1 to 4 heteroatoms selected from N, O, S, Se, Te, Si, and P.

As used herein, when a definition is not otherwise provided, the energy level is the highest occupied molecular orbital (HOMO) energy level or the lowest unoccupied molecular orbital (LUMO) energy level.

As used herein, when a definition is not otherwise provided, a work function or energy level is expressed as an absolute value from a vacuum level. In addition, when the work function or the energy level is referred to be deep, high, or large, it may have a large absolute value based on "0 eV" of the vacuum level while when the work function or the energy level is referred to be shallow, low, or small, it may have a small absolute value based on "0 eV" of the vacuum level. In addition, a difference between the work function and/or the energy level may be a value obtained by subtracting a small value of the absolute value from a large value of the absolute value.

As used herein, when a definition is not otherwise provided, the HOMO energy level may be evaluated by the amount of photoelectrons emitted according to energy by irradiating UV light onto a thin film using AC-2 (Hitachi) or AC-3 (Riken Keiki Co., LTD.).

As used herein, when a definition is not otherwise provided, the LUMO energy level is obtained as follow: an energy bandgap is obtained using a UV-Vis spectrometer (Shimadzu Corporation), and then the LUMO energy level is calculated from the energy bandgap and the measured HOMO energy level.

Hereinafter, a sensor-embedded display panel according to some example embodiments is described.

The sensor-embedded display panel according to some example embodiments may be a display panel capable of performing a display function and a biometric recognition function, and may be an in-cell type display panel in which a sensor performing a biometric recognition function is embedded in the display panel.

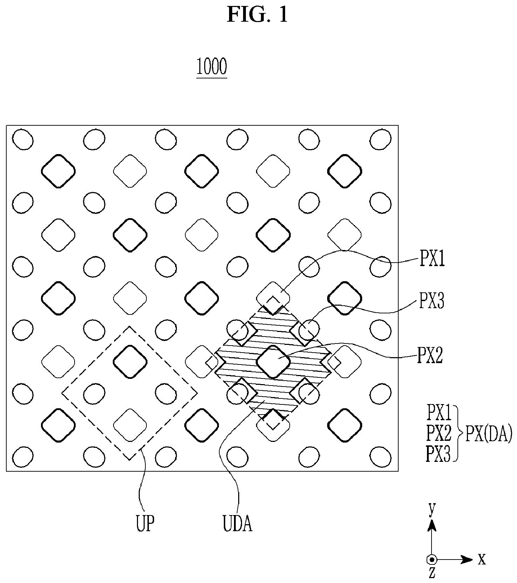

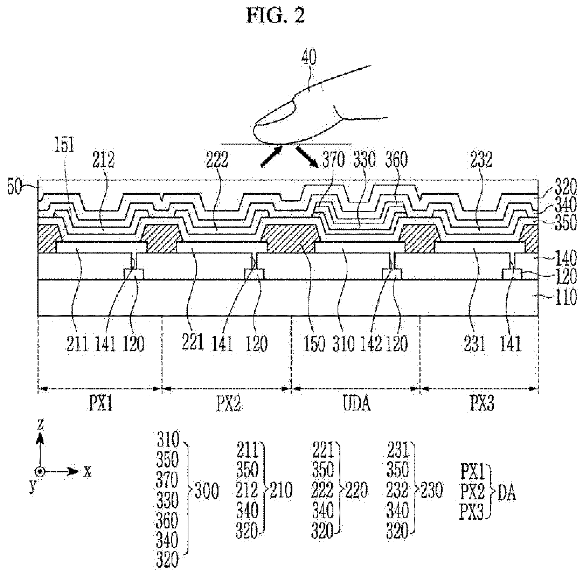

FIG. 1 is a plan view illustrating an example of a sensor-embedded display panel according to some example embodiments, and FIG. 2 is a cross-sectional view illustrating an example of a sensor-embedded display panel according to some example embodiments.

Referring to FIGS. 1 and 2, a sensor-embedded display panel 1000 according to some example embodiments includes a plurality of subpixels PXs displaying different colors. The plurality of subpixels PXs may be configured to display at least three primary colors, for example, a first subpixel PX1, a second subpixel PX2, and a third subpixel PX3 displaying different first color, second color, and third color selected from red, green, and blue. For example, the first color, the second color, and the third color may be red, green, and blue, respectively. Displaying a color may refer to emitting light corresponding to the color (e.g., light in a wavelength spectrum of the color). The first subpixel PX1 may be a red subpixel displaying red, the second subpixel PX2 may be a green subpixel displaying green, and the third subpixel PX3 may be a blue subpixel displaying blue. However, the present inventive concepts are not limited thereto, and an auxiliary subpixel (not shown) such as a white subpixel displaying white may be further included.

The plurality of subpixels PXs including the first subpixel PX1, the second subpixel PX2, and the third subpixel PX3 may constitute one unit pixel UP to be arranged repeatedly along the row and/or column. In FIG. 1, a structure including one first subpixel PX1, one second subpixel PX2, and two third subpixels PX3 in the unit pixel UP is illustrated, but the present inventive concepts are not limited thereto. At least one first subpixel PX1, at least one second subpixel PX2, and at least one third subpixel PX3 may be included in the unit pixel UP. In the drawing, as an example, an arrangement of a Pentile type is illustrated, but the present inventive concepts are not limited thereto. The subpixels PXs may be arranged variously. An area occupied by the plurality of subpixels PXs and displaying colors by the plurality of subpixels PXs may be a display area DA displaying an image.

Each of the first subpixel PX1, the second subpixel PX2, and the third subpixel PX3 may include a light emitting element. As an example, the first subpixel PX1 may include a first light emitting element 210 configured to emit light of a wavelength spectrum of a first color, the second subpixel PX2 may include a second light emitting element 220 configured to emit light of a wavelength spectrum of a second color, and the third subpixel PX3 may include a third light emitting element 230 configured to emit light of a wavelength spectrum of a third color. The first subpixel PX1 may be configure to emit red light, the second subpixel PX2 may be configured to emit green light, and the third subpixel PX3 may be configured to emit blue light. However, the present inventive concepts are not limited thereto, and at least one of the first subpixel PX1, the second subpixel PX2, or the third subpixel PX3 may include a light emitting element configured to emit light of a combination of a first color, a second color, and a third color, that is, light in a white wavelength spectrum, and may display a first color, a second color, or a third color through a color filter (not shown).

The sensor-embedded display panel 1000 according to some example embodiments includes a light absorption sensor 300. The light absorption sensor 300 may be disposed in a non-display area UDA. The non-display area UDA may be an area other than the display area DA, in which the first subpixel PX1, the second subpixel PX2, the third subpixel PX3, and optionally auxiliary subpixels are not arranged. The display area DA may be configured to display a color, and the non-display area UDA may be a portion of an area of the display panel 1000 that excludes the display area DA. The light absorption sensor 300 may be in the non-display area UDA. The light absorption sensor 300 may be between at least two of the first subpixel PX1, the second subpixel PX2, or the third subpixel PX3, and may be in parallel with the first, second, and third light emitting elements 210, 220, and 230 in the display area DA.

The light absorption sensor 300 may be an optical type biometric sensor. The light absorption sensor 300 may be configured to absorb light emitted from at least one of the first, second, or third light emitting elements 210, 220, or 230 in the display area DA and then reflected by a recognition target 40 such as a living body or a tool, and then may be configured to convert the absorbed light into an electrical signal. Herein, the living body may be a finger, a fingerprint, a palm, an iris, a face, and/or a wrist, but is not limited thereto. The light absorption sensor 300 may be, for example, a fingerprint sensor, an illumination sensor, an iris sensor, a distance sensor (a depth sensor), a blood vessel distribution sensor, and/or a heart rate sensor, but is not limited thereto.

The light absorption sensor 300 may be on the substrate 110 at the same plane as the first, second, and third light emitting elements 210, 220, and 230, and may be embedded in the display panel 1000.

Referring to FIG. 2, the sensor-embedded display panel 1000 includes a substrate 110; a thin film transistor 120 on the substrate 110; an insulation layer 140 formed on the thin film transistor 120; a pixel definition layer 150 on the insulation layer 140; and first, second, and/or third light emitting elements 210, 220, and 230 and the light absorption sensor 300 on the substrate 110 in a space partitioned by the pixel definition layer 150, respectively.

The substrate 110 may be a light-transmitting substrate, for example, a glass substrate or a polymer substrate. The polymer substrate may include, for example, polycarbonate, polymethylmethacrylate, polyethyleneterephthalate, polyethylenenaphthalate, polyimide, polyamide, polyamideimide, polyethersulfone, polyorganosiloxane, styrene-ethylene-butylene-styrene, polyurethane, polyacryl, polyolefin, or any combination thereof, but is not limited thereto.

A plurality of thin film transistors 120 are formed on the substrate 110. One or more thin film transistor 120 may be included in each subpixel PX, and may include, for example, at least one switching thin film transistor and/or at least one driving thin film transistor. The substrate 110 on which the thin film transistor 120 is formed may be referred to as a thin film transistor substrate (TFT substrate) or a thin film transistor backplane (TFT backplane).

The insulation layer 140 may cover the substrate 110 and the thin film transistor 120 and may be formed on the whole surface of the substrate 110. The insulation layer 140 may be a planarization layer or a passivation layer, and may include an organic insulating material, an inorganic insulating material, an organic-inorganic insulating material, or any combination thereof. The insulation layer 140 may have a plurality of contact holes 141 for connecting the first, second, and third light emitting elements 210, 220, and 230 and the thin film transistor 120 and a plurality of contact holes 142 for electrically connecting the light absorption sensor 300 and the thin film transistor 120.

The pixel definition layer 150 may also be formed on the surface of the substrate 110 and may be between adjacent subpixels PXs to partition each subpixel PX. The pixel definition layer 150 may have a plurality of openings 151, and in the corresponding opening 151, any one of first, second, or third light emitting elements 210, 220, or 230 and the light absorption sensors 300 may be disposed.

The first, second and third light emitting elements 210, 220, and 230 are formed on the substrate 110 (or thin film transistor substrate), and are repeatedly arranged along the in-plane direction (e.g., xy direction) of the substrate 110. As described above, the first, second, and third light emitting elements 210, 220, and 230 may be included in the first subpixel PX1, the second subpixel PX2, and the third subpixel PX3, respectively. The first, second, and third light emitting elements 210, 220, and 230 may be electrically connected to separate thin film transistors 120 and may be driven independently.

The first, second, and third light emitting elements 210, 220, and 230 may each independently be configured to emit one light of a red wavelength spectrum, a green wavelength spectrum, a blue wavelength spectrum, or any combination thereof. Herein, the red wavelength spectrum, the green wavelength spectrum, and the blue wavelength spectrum may have a maximum emission wavelength (λₘₐₓ) of greater than about 600 nm and less than about 750 nm, about 500 nm to about 600 nm, and greater than or equal to about 400 nm and less than about 500 nm, respectively.

The first, second, and third light emitting elements 210, 220, and 230 may be, for example, light emitting diodes and may be, for example, an organic light emitting diode including an organic light emitter, an inorganic light emitting diode including an inorganic light emitter, an organic-inorganic light-emitting diode including an organic-inorganic light emitter, or a micro light-emitting diode in which micro-units of light emitters are arranged.

The light absorption sensor 300 may be formed on the substrate 110 (or the thin film transistor substrate), and may be randomly or regularly arranged along the in-plane direction (e.g., xy direction) of the substrate 110. As described above, the light absorption sensor 300 may be disposed in the non-display area UDA, and may be connected to a separate thin film transistor 120 to be independently driven. The light absorption sensor 300 may be configured to absorb light of the same wavelength spectrum as the light emitted from at least one of the first, second, or third light emitting elements 210, 220, or 230, for example, a red wavelength spectrum and a green wavelength spectrum, a blue wavelength spectrum, and any combination thereof. The light absorption sensor 300 may be, for example, a photoelectric diode, and may be, for example, an organic photoelectric diode including an organic light absorption material.

For example, the first, second, and third light emitting elements 210, 220, and 230 may be organic light emitting diodes, and the light absorption sensor 300 may be an organic photoelectric diode.

As shown in at least FIG. 2, the first, second, and third light emitting elements 210, 220, and 230 may include separate, respective light emitting layer 212, 222, and 232. Each of the first, second, and third light emitting elements 210, 220, and 230 and the light absorption sensor 300 may include pixel electrodes 211, 221, 231, and 310; a common electrode 320 facing the pixel electrodes 211, 221, 231, and 310 and to which a common voltage is applied; and light emitting layers 212, 222, and 232 or a light absorbing layer 330; a first common auxiliary layer 340 and a second common auxiliary layer 350 between the pixel electrodes 211, 221, 231, and 310 and the common electrode 320.

The first, second, and third light emitting elements 210, 220, and 230 and the light absorption sensor 300 may be arranged in parallel along the in-plane direction (e.g., xy direction) of the substrate 110 (e.g., a surface direction of the substrate 110), and they share the common electrode 320, the first common auxiliary layer 340 under the common electrode 320, and the second common auxiliary layer 350 facing the first common auxiliary layer 340.

The common electrode 320 is continuously formed on the light emitting layers 212, 222, and 232 and the light absorbing layer 330, and is substantially formed on the whole surface of the substrate 110. The common electrode 320 may apply a common voltage (e.g., same voltage) to the first, second, and third light emitting elements 210, 220, and 230 and the light absorption sensor 300.

The first common auxiliary layer 340 may be between the light emitting layers 212, 222, and 232 and the light absorbing layer 330, and the common electrode 320, and may continuously be disposed on the light emitting layers 212, 222, and 232 and the light absorbing layer 330 and under the common electrode 320. The first common auxiliary layer 340 may extend continuously (e.g., as a single, continuous piece of material) on the separate, respective light emitting layers 212, 222, and 232 and the light absorbing layer 330. The common electrode 320 may be on the first common auxiliary layer 340 and may be configured to apply a common voltage to the first, second, and third light emitting elements 210, 220, and 230 and the light absorption sensor 300.

The first common auxiliary layer 340 may be an electron auxiliary layer that facilitates injection and/or transfer of charge carriers (e.g., electrons) from the common electrode 320 to the light emitting layers 212, 222, and 232. For example, the Lowest Unoccupied Molecular Orbital (LUMO) energy level of the first common auxiliary layer 340 may be between the LUMO energy level of the light emitting layers 212, 222, and 232 (e.g., the LUMO energy level of each of the light emitting layers 212, 222, and 232) and the work function of the common electrode 320. The work function of the common electrode 320, the LUMO energy level of the first common auxiliary layer 340, and the LUMO energy level of the light emitting layers 212, 222, and 232 may become sequentially shallow. On the other hand, the LUMO energy level of the first common auxiliary layer 340 may be shallower than the LUMO energy level of the light absorbing layer 330 and the work function of the common electrode 320, respectively.

The first common auxiliary layer 340 may include an organic material, an inorganic material, an organic-inorganic material, or any combination thereof satisfying the LUMO energy level, for example a halogenated metal such as LiF, NaCl, CsF, RbCI, and RbI; a lanthanides metal such as Yb; a metal oxide such as Li₂O or BaO; Liq (lithium quinolate), Alq3 (tris(8-hydroxyquinolinato)aluminum), 1,3,5-tri[(3-pyridyl)-phen-3-yl]benzene, 2,4,6-tris (3'-(pyridin-3-yl)biphenyl-3-yl)-1,3,5-triazine, 2-(4-(N-phenylbenzoimidazolyl-1-ylphenyl)-9,10-dinaphthylanthracene, TPBi (1,3,5-tri(1-phenyl-1H-benzo[d]imidazol-2-yl)phenyl), BCP (2,9-dimethyl-4,7-diphenyl-1,10-phenanthroline), Bphen (4,7-diphenyl-1,10-phenanthroline), TAZ (3-(4-biphenylyl)-4-phenyl-5-tertbutylphenyl-1,2,4-triazole), NTAZ (4-(naphthalen-1-yl)-3,5-diphenyl-4H-1,2,4-triazole), tBu-PBD (2-(4-biphenylyl)-5-(4-tert-butylphenyl)-1,3,4-oxadiazole), BAIq (bis(2-methyl-8-quinolinolato-N1,O8)-(1,1'-biphenyl-4-olato)aluminum), Bebq₂ (berylliumbis(benzoquinolin-10-olate), ADN (9,10-di(naphthalene-2-yl)anthracene), BmPyPhB (1,3-bis[3,5-di(pyridin-3-yl)phenyl]benzene), or any combination thereof, but is not limited thereto. The first common auxiliary layer 340 may be one layer or two or more layers.

The second common auxiliary layer 350 may be between the light emitting layers 212, 222, and 232 and the light absorbing layer 330, and the pixel electrodes 211, 221, 231, and 310 and may continuously be disposed under the light emitting layers 212, 222, and 232 and the light absorbing layer 330 and on the pixel electrodes 211, 221, 231, and 310.

The second common auxiliary layer 350 may be a hole auxiliary layer that facilitates injection and/or transfer of charge carriers (e.g., holes) from the pixel electrodes 211, 221, and 231 to the light emitting layers 212, 222, and 232. For example, the Highest Occupied Molecular Orbital (HOMO) energy level of the second common auxiliary layer 350 may be between the HOMO energy level of the light emitting layers 212, 222, and 232 and the work function of the pixel electrodes 211, 221, and 231. The work function of the pixel electrodes 211, 221, and 231, the HOMO energy level of the second common auxiliary layer 350, and the HOMO energy level of the light emitting layers 212, 222, and 232 may become sequentially deep.

The second common auxiliary layer 350 may include an organic material, an inorganic material, an organic-inorganic material, or any combination thereof satisfying the HOMO energy level, for example a phthalocyanine compound such as copper phthalocyanine; DNTPD (N,N'-diphenyl-N,N'-bis-[4-(phenyl-m-tolyl-amino)-phenyl]-biphenyl-4,4'-diamine), m-MTDATA (4,4',4"-[tris(3-methylphenyl)phenylamino] triphenylamine), TDATA (4,4'4"-tris(N,N-diphenylamino)triphenylamine), 2-TNATA (4,4',4"-tris{N,N'-(2-naphthyl)-N-phenylamino}-triphenylamine), PEDOT/PSS (poly(3,4-ethylenedioxythiophene)/poly(4-styrenesulfonate)), PANI/DBSA (polyaniline/dodecylbenzenesulfonic acid), PANI/CSA (polyaniline/Camphor sulfonic acid), PANI/PSS (polyaniline/poly(4-styrenesulfonate)), NPB (N,N'-di(naphthalene-I-yl)-N,N'-diphenylbenzidine), polyetherketone including triphenylamine (TPAPEK), 4-isopropyl-4'-methyldiphenyliodonium[tetrakis(pentafluorophenyl)borate], HAT-CN (dipyrazino[2,3-f: 2',3'-h] quinoxaline-2,3,6,7,10,11-hexacarbonitrile), a carbazole-based derivative such as N-phenylcarbazole, polyvinylcarbazole, and the like, a fluorine-based derivative, TPD (N,N'-bis(3-methylphenyl)-N,N'-diphenyl-[1,1-biphenyl]-4,4'-diamine), a triphenylamine-based derivative such as TCTA (4,4',4"-tris(N-carbazolyl)triphenylamine), NPB (N,N'-di(naphthalene-l-yl)-N,N'-diphenyl-benzidine), TAPC (4,4'-cyclohexylidene bis[N,N-bis(4-methylphenyl)benzenamine]), HMTPD (4,4'-bis[N,N'-(3-tolyl)amino]-3,3'-dimethylbiphenyl), mCP (1,3-Bis(N-carbazolyl)benzene), or any combination thereof, but is not limited thereto. The second common auxiliary layer 350 may be one layer or two or more layers.

Each of the first, second and third light emitting elements 210, 220, and 230 and the light absorption sensor 300 includes pixel electrodes 211, 221, 231, and 310 facing the common electrode 320. One of the pixel electrodes 211, 221, 231, or 310 and the common electrode 320 is an anode and the other is a cathode. For example, the pixel electrodes 211, 221, 231, and 310 may be an anode, and the common electrode 320 may be a cathode. The pixel electrodes 211, 221, 231, and 310 are separated for each subpixel PX, and are electrically connected to each separate thin film transistor 120 to be independently driven.

Each of the pixel electrodes 211, 221, 231, and 310 and the common electrode 320 may be a light-transmitting electrode or a reflective electrode. For example, at least one of the pixel electrodes 211, 221, 231, or 310 and the common electrode 320 may be a light-transmitting electrode.

The light-transmitting electrode may be a transparent electrode or a semi-transmissive electrode. The transparent electrode may have a light transmittance of greater than or equal to about 85%, greater than or equal to about 90%, or greater than or equal to about 95%, and the semi-transmissive electrode may have a light transmittance of greater than or equal to about 30% and less than about 85%, about 40 % to about 80% or about 40% to 75%. The transparent electrode and the semi-transmissive electrode may include, for example, at least one of an oxide conductor, a carbon conductor, or a metal thin film. The oxide conductor may include, for example, one or more selected from indium tin oxide ITO, indium zinc oxide IZO, zinc tin oxide ZTO, aluminum tin oxide ATO, and aluminum zinc oxide AZO, the carbon conductor may be at least one selected from graphene and carbon nanomaterials, and the metal thin film may be a very thin film including aluminum Al, magnesium Mg, silver Ag, gold Au, magnesium-silver Mg-Ag, magnesium-aluminum Mg-Al, an alloy thereof, or any combination thereof.

The reflective electrode may include a reflective layer having a light transmittance of less than or equal to about 5% and/or a reflectance of greater than or equal to about 80%, and the reflective layer may include an optically opaque material. The optically opaque material may include a metal, a metal nitride, or any combination thereof, for example silver Ag, copper Cu, aluminum Al, gold Au, titanium Ti, chromium Cr, nickel Ni, an alloy thereof, a nitride thereof (e.g., TiN), or any combination thereof, but is not limited thereto. The reflective electrode may be formed of a reflective layer or may have a stacked structure of a reflective layer/transmissive layer or a transmissive layer/reflective layer/transmissive layer, and the reflective layer may be one layer or two or more layers.

For example, when the pixel electrodes 211, 221, 231, and 310 are light-transmitting electrodes and the common electrode 320 is a reflective electrode, the sensor-embedded display panel 1000 may be a bottom emission type display panel configured to emit light toward the substrate 110. For example, when the pixel electrodes 211, 221, 231, and 310 are reflective electrodes and the common electrode 320 is a light-transmitting electrode, the sensor-embedded display panel 1000 may be a top emission type display panel configured to emit light to the opposite side of the substrate 110. For example, when the pixel electrodes 211, 221, 231, and 310 and the common electrode 320 are all light-transmitting electrodes, the sensor-embedded display panel 1000 may be a both side emission type display panel.

For example, the pixel electrodes 211, 221, 231, and 310 may be reflective electrodes and the common electrode 320 may be a transflective electrode. In this case, the sensor-embedded display panel 1000 may have a microcavity structure. In the microcavity structure, reflection may occur repeatedly between the reflective electrode and the transflective electrode separated by a particular (or, alternatively, predetermined) optical length (e.g., a distance between the transflective electrode and the reflective electrode) and light of a particular (or, alternatively, predetermined) wavelength spectrum may be enhanced to improve optical properties.

For example, among the light emitted from the light emitting layers 212, 222, and 232 of the first, second, and third light emitting elements 210, 220, and 230, light of a particular (or, alternatively, predetermined) wavelength spectrum may be repeatedly reflected between the transflective layer and the reflective layer and then may be modified. Among the modified light, light of a wavelength spectrum corresponding to a resonance wavelength of a microcavity may be enhanced to exhibit amplified light emission characteristics in a narrow wavelength region. Accordingly, the sensor-embedded display panel 1000 may express colors with high color purity.

For example, among the light incident on the light absorption sensor 300, light of a particular (or, alternatively, predetermined) wavelength spectrum may be repeatedly reflected between the semi-transmissive layer and the reflective layer to be modified. Among the modified light, light of a wavelength spectrum corresponding to the resonance wavelength of a microcavity may be enhanced to exhibit amplified photoelectric conversion characteristics in a narrow wavelength region. Accordingly, the light absorption sensor 300 may exhibit high photoelectric conversion characteristics in a narrow wavelength region.

Each of the first, second, and third light emitting elements 210, 220, and 230 includes light emitting layers 212, 222, and 232 between the pixel electrodes 211, 221, and 231 and the common electrode 320. Each of the light emitting layer 212 included in the first light emitting element 210, the light emitting layer 222 included in the second light emitting element 220, and the light emitting layer 232 included in the third light emitting element 230 may be configured to emit light in the same or different wavelength spectra and may be configured to emit light in, for example a red wavelength spectrum, a green wavelength spectrum, a blue wavelength spectrum, or any combination thereof.

For example, when the first light emitting element 210, the second light emitting element 220, and the third light emitting element 230 are a red light emitting elements, a green light emitting element, and a blue light emitting element, respectively, the light emitting layer 212 may be a red light emitting layer configured to emit light in a red wavelength spectrum, the light emitting layer 222 included in the second light emitting element 220 may be a green light emitting layer configured to emit light in a green wavelength spectrum, and the light emitting layer 232 included in the third light emitting element 230 may be a blue light emitting layer configured to emit light in a blue wavelength spectrum. Herein, the red wavelength spectrum, the green wavelength spectrum, and the blue wavelength spectrum may have a maximum emission wavelength of greater than about 600 nm and less than about 750 nm, about 500 nm to about 600 nm, and greater than or equal to about 400 nm and less than about 500 nm, respectively. The first subpixel PX1 may include the first light emitting element 210 and may be configured to emit light in the red wavelength spectrum, the second subpixel PX2 may include the second light emitting element 220 and may be configured to emit light in the green wavelength spectrum, and the third subpixel PX3 may include the third light emitting element 230 and may be configured to emit light in the blue wavelength spectrum.

For example, when at least one of the first light emitting element 210, the second light emitting element 220, or the third light emitting element 230 is a white light emitting element, the light emitting layer of the white light emitting element may be configured to emit light of a full visible light wavelength spectrum, for example, light in a wavelength spectrum of greater than or equal to about 380 nm and less than about 750 nm, about 400 nm to about 700 nm, or about 420 nm to about 700 nm.

The light emitting layers 212, 222, and 232 may each include an organic light emitter, a quantum dot, a perovskite, or any combination thereof as a light emitter. For example, the light emitting layers 212, 222, and 232 may include an organic light emitter, and may include at least one host material and a fluorescent or phosphorescent dopant.

The organic light emitter may be, for example, an organometallic compound including perylene or a derivative thereof; rubrene or a derivative thereof; 4-(dicyanomethylene)-2-methyl-6-[p-(dimethylamino)styryl]-4H-pyran or a derivative thereof; coumarin or a derivative thereof; carbazole or a derivative thereof; Pt, Os, Ti, Zr, Hf, Eu, Tb, Tm, Rh, Ru, Re, Be, Mg, Al, Ca, Mn, Co, Cu, Zn, Ga, Ge, Pd, Ag, and/or Au.

The quantum dot may include, for example, a Group II-VI semiconductor compound, a Group III-V semiconductor compound, a Group IV-VI semiconductor compound, a Group IV semiconductor compound, a Group I-III-VI semiconductor compound, a Group I-II-IV-VI semiconductor compound, a Group II-III-V semiconductor compound, or any combination thereof. The Group II-IV semiconductor compound may be, for example, selected from a binary element semiconductor compound selected from CdSe, CdTe, ZnS, ZnSe, ZnTe, ZnO, HgS, HgSe, HgTe, MgSe, MgS, or a combination thereof; a ternary element semiconductor compound selected from CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS,, or a combination thereof; and a quaternary element semiconductor compound selected from HgZnTeS, CdZnSeS, CdZnSeTe, CdZnSTe, CdHgSeS, CdHgSeTe, CdHgSTe, HgZnSeS, HgZnSeTe, HgZnSTe, or a combination thereof, but is not limited thereto. The Group III-V semiconductor compound may be, for example, selected from a binary element semiconductor compound selected from GaN, GaP, GaAs, GaSb, AlN, AIP, AlAs, AlSb, InN, InP, InAs, InSb, or a combination thereof; a ternary element semiconductor compound selected from GaNP, GaNAs, GaNSb, GaPAs, GaPSb, AlNP, AlNAs, AlNSb, AlPAs, AlPSb, InNP, InNAs, InNSb, InPAs, InPSb, or a combination thereof; and a quaternary element semiconductor compound selected from GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or a combination thereof, but is not limited thereto. The Group IV-VI semiconductor compound may be, for example, selected from a binary element semiconductor compound selected from SnS, SnSe, SnTe, PbS, PbSe, PbTe, or a combination thereof; a ternary element semiconductor compound selected from SnSeS, SnSeTe, SnSTe, PbSeS, PbSeTe, PbSTe, SnPbS, SnPbSe, SnPbTe, or a combination thereof; and a quaternary element semiconductor compound selected from SnPbSSe, SnPbSeTe, SnPbSTe, or a combination thereof, but is not limited thereto. The Group IV semiconductor compound may be, for example, selected from a single-element semiconductor compound such as Si, Ge, or a combination thereof; and a binary element compound selected from SiC, SiGe, or a combination thereof, but is not limited thereto. The Group I-III-VI semiconductor compound may be, for example, CuInSe₂, CuInS₂, CuInGaSe, CuInGaS, or a combination thereof, but is not limited thereto. The Group I-II-IV-VI semiconductor compound may be, for example, CuZnSnSe, CuZnSnS, or a combination thereof, but is not limited thereto. The Group II-III-V semiconductor compound may be, for example, InZnP, but is not limited thereto.

The perovskite may be CH₃NH₃PbBr₃, CH₃NH₃PbI₃, CH₃NH₃SnBr₃, CH₃NH₃SnI₃, CH₃NH₃Sn₁ₓPbₓBr₃, CH₃NH₃Sn₁ₓPbₓI₃, HC(NH₂)₂PbI₃, HC(NH₂)₂SnI₃, (C₄H₉NH₃)₂PbBr₄, (C₆H₅CH₂NH₃)₂PbBr₄, (C₆H₅CH₂NH₃)₂PbI₄, (C₆H₅C₂H₄NH₃)₂PbBr₄, (C₆H₁₃NH₃)₂(CH₃NH₃)ₙ₁PbₙI₃ₙ₊₁, or any combination thereof, but is not limited thereto.

The thickness of the light emitting layers 212, 222, and 232 may each independently be about 5 nm to about 300 nm, and within the above range, about 10 nm to about 250 nm, about 20 nm to about 200 nm, or about 30 nm to about 180 nm.

The light absorption sensor 300 includes a light absorbing layer 330 between the pixel electrode 310 and the common electrode 320. The light absorbing layer 330 may be (e.g., may extend) in parallel with the separate, respective light emitting layers 212, 222, and 232 of the first, second, and third light emitting elements 210, 220, and 230 along the in-plane direction (e.g., xy direction) of the substrate 110 (e.g., along the surface direction of the substrate 110). The light absorbing layer 330 and the light emitting layers 212, 222, and 232 may be on the same plane.

The light absorbing layer 330 may be a photoelectric conversion layer configured to absorb light of a particular (or, alternatively, predetermined) wavelength spectrum and convert the absorbed light into an electrical signal. The light absorbing layer 330 may be configured to absorb light emitted from at least one of the first, second, or third light emitting elements 210, 220, or 230 and then reflected by the recognition target 40, and may be configured to convert the absorbed light into an electrical signal. The light absorbing layer 330 may be configured to absorb light of a red wavelength spectrum, a green wavelength spectrum, a blue wavelength spectrum, an infrared wavelength spectrum, or any combination thereof.

For example, the light absorbing layer 330 may be configured to selectively absorb light of a red wavelength spectrum belonging to greater than about 600 nm and less than about 750 nm, and may be configured to absorb light emitted from the red light emitting element among the first, second, and third light emitting elements 210, 220, and 230 and then reflected by the recognition target 40.

For example, the light absorbing layer 330 may be configured to selectively absorb light of a green wavelength spectrum belonging to about 500 nm to about 600 nm, and may be configured to absorb light emitted from the green light emitting element among the first, second and third light emitting elements 210, 220, and 230 and then reflected by the recognition target 40.

For example, the light absorbing layer 330 may be configured to selectively absorb light in a blue wavelength spectrum belonging to greater than or equal to about 380 nm and less than about 500 nm, and may be configured to absorb light emitted from the blue light emitting element among the first, second, and third light emitting elements 210, 220, and 230 and then reflected by the recognition target 40.

For example, the light absorbing layer 330 may be configured to absorb light of a red wavelength spectrum, a green wavelength spectrum, and a blue wavelength spectrum, that is, light of a full visible wavelength spectrum of greater than or equal to about 380 nm and less than about 750 nm. The light absorbing layer 330 may be configured to absorb light emitted from the light emitting elements 210, 220, and 230 and then reflected by the recognition target 40.

The light absorbing layer 330 may include a p-type semiconductor and/or an n-type semiconductor for photoelectric conversion of the absorbed light. The p-type semiconductor and the n-type semiconductor may form a pn junction, and after receiving light from the outside (e.g., light reflected by a recognition target that is external to the sensor-embedded display panel 1000) to generate excitons, the generated excitons may be separated into holes and electrons, such that the received light may be absorbed and converted into an electrical signal. Each of the p-type semiconductor and the n-type semiconductor may be one or two or more, and each may be a light absorbing material configured to absorb light of at least a portion of a wavelength spectrum of the visible light wavelength spectrum. For example, the p-type semiconductor and/or the n-type semiconductor may be a light absorbing material configured to absorb light in the full visible wavelength spectrum. For example, the p-type semiconductor and/or the n-type semiconductor may be light absorbing materials configured to selectively absorb one or both of a red wavelength spectrum, a green wavelength spectrum, and a blue wavelength spectrum. A plurality of materials configured to absorb light of different wavelength spectrums may be combined to absorb light in the full visible wavelength spectrum. The p-type semiconductor and/or the n-type semiconductor may be an organic light absorbing material.

For example, the light absorbing layer 330 may include an organic light absorbing material (e.g., an organic material) configured to selectively absorb light in a green wavelength spectrum, and for example, may include a p-type semiconductor configured to selectively absorb light in a green wavelength spectrum.

The p-type semiconductor may be an organic material, an inorganic material, or an organic-inorganic material that satisfies a particular (or, alternatively, predetermined) HOMO energy level, for example, a HOMO energy level of about 5.0 eV to about 6.0 eV, about 5.1 eV to about 5.9 eV, about 5.2 eV to about 5.8 eV, or about 5.3 eV to about 5.8 eV.

The p-type semiconductor may be a low-molecular organic compound capable of being deposited, for example, an organic compound including an electron donating moiety and an electron accepting moiety. For example, it may be represented by Chemical Formula A.

[Chemical Formula A] EDM - LM - EAM

In Chemical Formula A,
EDM may be an electron-donating moiety,
EAM may be an electron accepting moiety, and
LM may be a π conjugated linking moiety that links the electron donating moiety and the electron accepting moiety.

For example, a p-type semiconductor configured to selectively absorb light in a green wavelength spectrum (hereinafter referred to as a "green p-type semiconductor") may be, for example, an organic compound represented by Chemical Formula A-1.

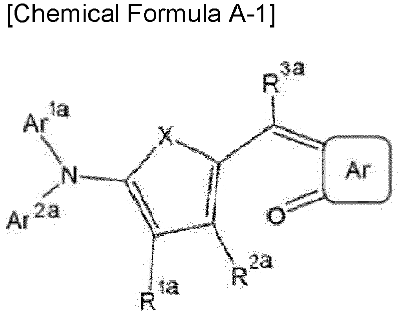

In Chemical Formula A-1,
X may be O, S, Se, Te, SO, SO₂, or SiR^{a}R^{b},
Ar may be a substituted or unsubstituted C6 to C30 arylene group, a substituted or unsubstituted C3 to C30 heterocyclic group, or a fused ring of the foregoing two or more,
Ar^{1a} and/or Ar^{2a} may be a substituted or unsubstituted C6 to C30 aryl group or a substituted or unsubstituted C3 to C30 heteroaryl group,
Ar^{1a} and Ar^{2a} may each independently be present alone or may be linked with each other to form a fused ring, and
R^{1a} to R^{3a}, R^{a}, and R^{b} may each independently be hydrogen, deuterium, a substituted or unsubstituted C1 to C30 alkyl group, a substituted or unsubstituted C1 to C30 alkoxy group, a substituted or unsubstituted C6 to C30 aryl group, a substituted or unsubstituted C3 to C30 heteroaryl group, a halogen, a cyano group, or any combination thereof.

For example, Ar^{1a} and Ar^{2a} may each independently be one of a substituted or unsubstituted phenyl group, a substituted or unsubstituted naphthyl group, a substituted or unsubstituted anthracenyl group, a substituted or unsubstituted phenanthrenyl group, a substituted or unsubstituted pyridinyl group, a substituted or unsubstituted pyridazinyl group, a substituted or unsubstituted pyrimidinyl group, a substituted or unsubstituted pyrazinyl group, a substituted or unsubstituted quinolinyl group, a substituted or unsubstituted isoquinolinyl group, a substituted or unsubstituted naphthyridinyl group, a substituted or unsubstituted cinnolinyl group, a substituted or unsubstituted quinazolinyl group, a substituted or unsubstituted phthalazinyl group, a substituted or unsubstituted benzotriazinyl group, a substituted or unsubstituted pyridopyrazinyl group, a substituted or unsubstituted pyridopyrimidinyl group, or a substituted or unsubstituted pyridopyridazinyl group.

Ar^{1a} and Ar^{2a} may be linked with each other to form a ring. For example, Ar^{1a} and Ar^{2a} may be linked with each other by one of a single bond, -(CR^{c}R^{d})ₙ₁- (n1 is an integer of 1 or 2), -O-, -S-, -Se-, -N=, -NR^{e}-, -SiR^{f}R^{g}- or -GeR^{h}Rⁱ- to form a ring. Herein, R^{c} to Rⁱ may each independently be hydrogen, a substituted or unsubstituted C1 to C30 alkyl group, a substituted or unsubstituted C6 to C30 aryl group, a substituted or unsubstituted C3 to C30 heteroaryl group, a substituted or unsubstituted C1 to C6 alkoxy group, a halogen, a cyano group, or any combination thereof.

Specifically, the green p-type semiconductor may include one or more of the organic compounds represented by any one of Chemical Formulas A-2 to A-9.

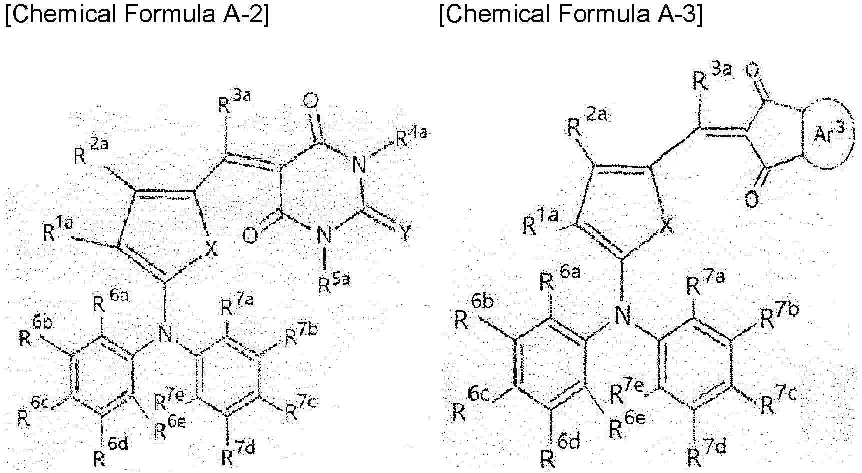

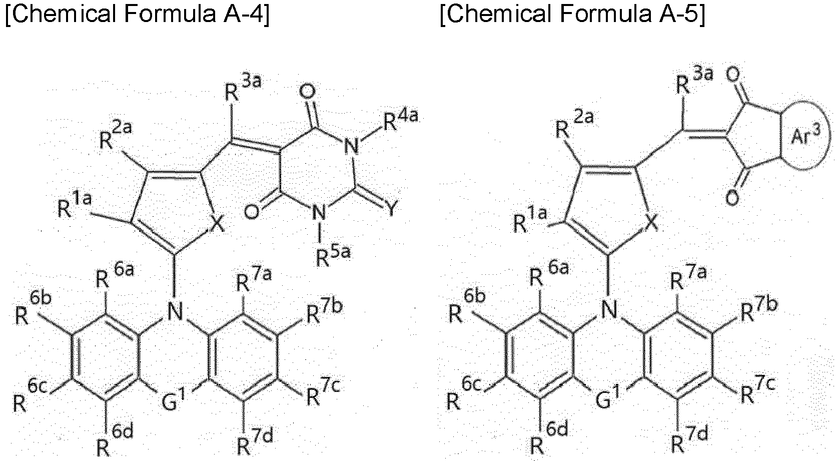

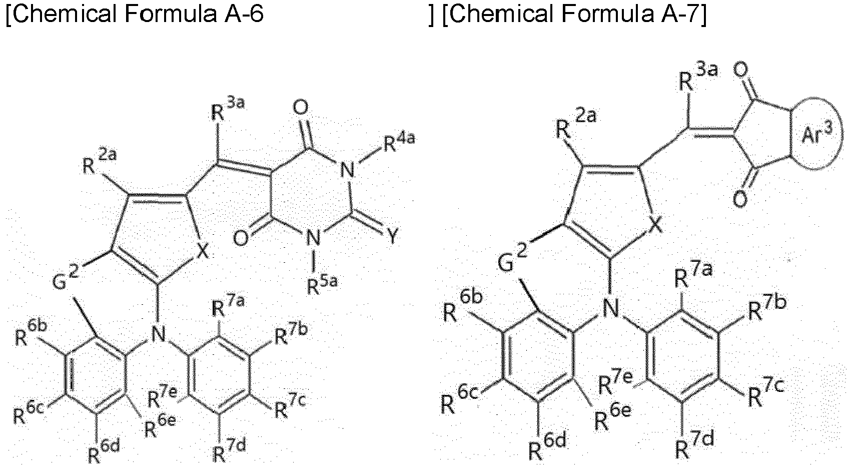

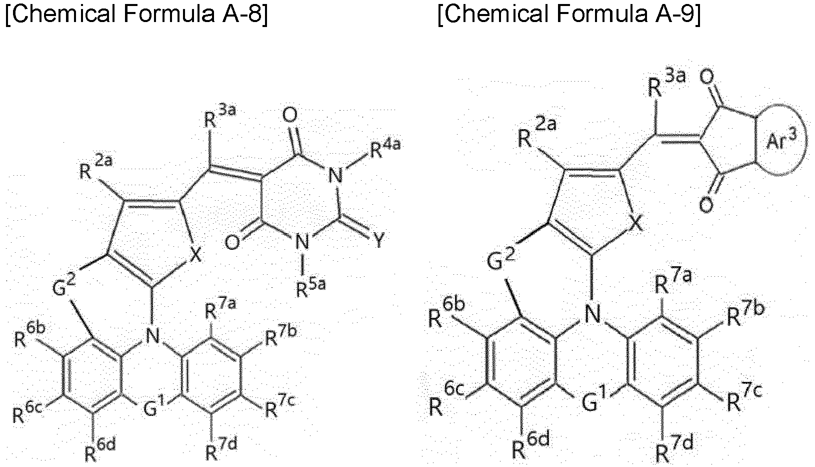

In Chemical Formulas A-2 to A-9,
X may be O, S, Se, Te, SO, SO₂, or SiR^{a}R^{b},
Ar³ may be a substituted or unsubstituted C6 to C30 arylene group, a substituted or unsubstituted C3 to C30 heterocyclic group, or a fused ring of the foregoing two or more,
R^{1a} to R^{5a}, R^{a}, and R^{b} may each independently be hydrogen, deuterium, a substituted or unsubstituted C1 to C30 alkyl group, a substituted or unsubstituted C1 to C30 alkoxy group, a substituted or unsubstituted C6 to C30 aryl group, a substituted or unsubstituted C3 to C30 heteroaryl group, a halogen, a cyano group, or any combination thereof,
G¹ and/or G² may each independently be a single bond, -(CR^{c}R^{d})ₙ₁- (n1 is an integer of 1 or 2), -O- , -S-, -Se-, -N=, -NR^{e}-, -SiR^{f}R^{g}-, or -GeR^{h}Rⁱ-, wherein R^{c} to R' may each independently be hydrogen, a substituted or unsubstituted C1 to C30 alkyl group, a substituted or unsubstituted C6 to C30 aryl group, a substituted or unsubstituted C3 to C30 heteroaryl group, a substituted or unsubstituted C1 to C6 alkoxy group, a halogen, a cyano group, or any combination thereof, R^{c} and R^{d}, R^{f} and R^{g}, and R^{h} and Rⁱ may each independently be present alone or may be linked with each other to provide a ring,
Y may be O, S, Se, Te, or C(R^{j})(CN), wherein R^{j} is hydrogen, a cyano group (-CN), or a C1 to C10 alkyl group,
R^{6a} to R^{6e} and R^{7a} to R^{7e} may each independently be hydrogen, a substituted or unsubstituted C1 to C30 alkyl group, a substituted or unsubstituted C1 to C30 alkoxy group, a substituted or unsubstituted C6 to C30 aryl group, a substituted or unsubstituted C3 to C30 heteroaryl group, a halogen, a cyano group, or any combination thereof, and
R^{1a} to R^{3a}, R^{6a} to R^{6e}, and R^{7a} to R^{7e} may each independently be present alone or may be linked with each other to provide a ring.

For example, Ar³ in Chemical Formulas A-3, A-5, A-7, and/or A-9 may be benzene, naphthylene, anthracene, thiophene, selenophene, tellurophene, pyridine, pyrimidine, or a fused ring of two therefrom.

The n-type semiconductor may be an organic material, inorganic material, or organic-inorganic material that satisfies a particular (or, alternatively, predetermined) LUMO energy level, for example, LUMO energy level of greater than or equal to about 3.3 eV, greater than or equal to about 3.4 eV, or greater than or equal to about 3.5 eV, and less than or equal to about 5.5 eV, less than or equal to about 5.3 eV, or less than or equal to about 5.0 eV. The n-type semiconductor may include, for example, fullerene or a fullerene derivative such as C60, C70, C78, or C80; thiophene or a thiophene derivative; perylene diimide or a derivative thereof; naphthalene diimide or a derivative thereof; a metal organic complex such as tris(8-hydroxyquinolinato)aluminum (Alq3), subphthalocyanine (SubPc), or phthalocyanine (Pc), or a derivative thereof; or any combination thereof, but is not limited thereto.

The light absorbing layer 330 may be an intrinsic layer (I layer) in which a p-type semiconductor and an n-type semiconductor are blended in a bulk heterojunction form. Herein, the p-type semiconductor and the n-type semiconductor may be blended in a volume ratio (thickness ratio) of about 1:9 to about 9:1, within the range, for example about 2:8 to about 8:2, about 3:7 to about 7:3, about 4:6 to about 6:4, or about 5:5.

The thickness of the light absorbing layer 330 may each independently be about 5 nm to about 300 nm, and within the above range, about 10 nm to about 250 nm, about 20 nm to about 200 nm, or about 30 nm to about 180 nm. A difference in thickness between the light emitting layers 212, 222, and 232 and the light absorbing layer 330 may be less than or equal to about 20 nm, and within the above range, less than or equal to about 15 nm, less than or equal to about 10 nm, or less than or equal to about 5 nm, and the light emitting layers 212, 222, and 232 and the light absorbing layer 330 may have substantially the same thickness.

The light absorption sensor 300 includes an n-type semiconductor layer 360 and a p-type semiconductor layer 370 between the pixel electrode 310 and the common electrode 320.

The n-type semiconductor layer 360 may be between the light absorbing layer 330 and the first common auxiliary layer 340, and thus electrical mismatching between the light absorbing layer 330 and the first common auxiliary layer 340 may be supplemented.

As described above, the first common auxiliary layer 340 may have electrical characteristics that facilitate injection and/or transfer of charge carriers (e.g., electrons) from the common electrode 320 to the light emitting layers 212, 222, 232 of the first, second, and third light emitting elements 210, 220, and 230, whereas such electrical characteristics of the first common auxiliary layer 340 may not be applied equally to the case between the light absorbing layer 330 and the common electrode 320 of the light absorption sensor 300.

That is, a direction of transfer of electric charge carriers (e.g., electrons) in the light absorption sensor 300 is different from that in the first, second, and third light emitting elements 210, 220, and 230, and electrical characteristics of the light absorbing layer 330 is different from that of the light emitting layers 212, 222, and 232. Unlike the role of the first common auxiliary layer 340 that facilitates the injection and/or transfer of charge carriers (e.g., electrons) from the common electrode 320 to the light emitting layers 212, 222, and 232 in the first, second, and third light emitting element 210, 220, and 230, the first common auxiliary layer 340 between the light absorbing layer 330 and the common electrode 320 may act as a barrier to prevent transfer and/or extraction of charge carriers (e.g., electrons) from the light absorbing layer 330 to the common electrode 320, and thus may deteriorate electrical characteristics of the light absorption sensor 300.

The n-type semiconductor layer 360 may be between the light absorbing layer 330 and the common electrode 320. The n-type semiconductor layer 360 is between the light absorbing layer 330 and the first common auxiliary layer 340 to compensate for electrical mismatch between the light absorbing layer 330 and the first common auxiliary layer 340, so that charge carriers (e.g., electrons) generated in the light absorbing layer 330 may pass through the n-type semiconductor layer 360 and the first common auxiliary layer 340 to be effectively transferred and/or extracted to the common electrode 320. Accordingly, the photoelectric conversion efficiency of the light absorption sensor 300 may be increased to improve electrical characteristics.

The n-type semiconductor layer 360 may include an n-type semiconductor. The n-type semiconductor may be an organic material, an inorganic material, or an organic-inorganic material that satisfies a particular (or, alternatively, predetermined) LUMO energy level, for example, an LUMO energy level of greater than or equal to about 3.3 eV, greater than or equal to about 3.4 eV, greater than or equal to about 3.5 eV, and less than or equal to about 5.5 eV, less than or equal to about 5.3 eV, or less than or equal to about 5.0 eV, and, for example, about 3.3 eV to about 5.5 eV, about 3.4 eV to about 5.3 eV, or about 3.5 eV to about 5.0 eV. The n-type semiconductor included in the n-type semiconductor layer 360 may be the same as or different from the n-type semiconductor included in the light absorbing layer 330. Restated, the light absorbing layer 330 may include a first n-type semiconductor and may further include a first p-type semiconductor forming a pn junction with the first n-type semiconductor, and the n-type semiconductor layer 360 my include a second n-type semiconductor that may be a same n-type semiconductor as or different n-type semiconductor from the first n-type semiconductor. For example, the n-type semiconductor may include fullerene or a fullerene derivative such as C60, C70, C78, or C80; thiophene or a thiophene derivative; perylene diimide or a derivative thereof; naphthalene diimide or a derivative thereof; a metal organic complex such as tris(8-hydroxyquinolinato)aluminum (Alq3), subphthalocyanine (SubPc), or phthalocyanine (Pc), or a derivative thereof; or any combination thereof, but is not limited thereto.

The thickness of the n-type semiconductor layer 360 may be thinner than the light absorbing layer 330. For example, the thickness of the n-type semiconductor layer 360 may be about 2 nm to about 100 nm, about 2 nm to about 80 nm, about 2 nm to about 50 nm, about 2 nm to about 30 nm, about 2 nm to about 20 nm, or about 2 nm to about 10 nm, but is not limited thereto.

The p-type semiconductor layer 370 may be under the light absorbing layer 330. The p-type semiconductor layer 370 may be between the light absorbing layer 330 and the second common auxiliary layer 350, and may compensate for electrical mismatch between the light absorbing layer 330 and the second common auxiliary layer 350.

As described above, the second common auxiliary layer 350 have electrical characteristics that facilitate injection and/or transfer of charge carriers (e.g., holes) from the pixel electrodes 211, 221, and 231 of the first, second, and third light emitting elements 210, 220, and 230 to the light emitting layers 212, 222, and 232, whereas such electrical characteristics of the second common auxiliary layer 350 of the first, second, and third light emitting elements 210, 220, and 230 may not be applied equally to the case between the light absorbing layer 330 and the pixel electrode 310 of the light absorption sensor 300.

That is, a direction of transfer of electric charge carriers (e.g., holes) in the light absorption sensor 300 is different from that of electric charges (e.g., holes) in the first, second, and third light emitting elements 210, 220, and 230, and electrical characteristics of the light absorbing layer 330 is different from that of the light emitting layers 212, 222, and 232. Unlike the role of the second common auxiliary layer 350 that facilitates the injection and/or transfer of charge carriers (e.g., holes) from the pixel electrodes 211, 221, and 231 to the light emitting layers 212, 222, and 232 in the first, second, and third light emitting elements 210, 220, and 230, the second common auxiliary layer 350 between the light absorbing layer 330 and the pixel electrode 310 may act as a barrier to prevent transfer and/or extraction of charge carriers (e.g., holes) from the light absorbing layer 330 to the pixel electrode 310, and thus may deteriorate electrical characteristics of the light absorption sensor 300.

The p-type semiconductor layer 370 may compensate for the electrical mismatch between the light absorbing layer 330 and the second common auxiliary layer 350, so that charge carriers (e.g., holes) generated in the light absorbing layer 330 may pass through the p-type semiconductor layer 370 and the second common auxiliary layer 350 to be effectively transferred and/or extracted to the pixel electrode 310. Accordingly, the photoelectric conversion efficiency of the light absorption sensor 300 may be increased, and thus the electrical characteristics of the light absorption sensor 300 may be improved.

The p-type semiconductor layer 370 may include a p-type semiconductor. The p-type semiconductor may be an organic material, an inorganic material, or an organic-inorganic material that satisfies a particular (or, alternatively, predetermined) HOMO energy level, and may have, for example, a HOMO energy level of about 5.0 eV to about 6.0 eV, about 5.1 eV to about 5.9 eV, about 5.2 eV to about 5.8 eV, or about 5.3 eV to about 5.8 eV. The p-type semiconductor included in the p-type semiconductor layer 370 may be the same as or different from the p-type semiconductor included in the light absorbing layer 330 (e.g., the p-type semiconductor layer 370 may include a second p-type semiconductor that may be a same p-type semiconductor as or different p-type semiconductor from a first p-type semiconductor of the light absorbing layer 330), and may be selected from the aforementioned p-type semiconductors, but is not limited thereto.

As described above, the sensor-embedded display panel 1000 according to some example embodiments includes the first, second, and third light emitting elements 210, 220, and 230 configured to emit light of a particular (or, alternatively, predetermined) wavelength spectrum to display colors, and the light absorption sensor 300 configured to absorb light reflected by the recognition target 40 and convert the absorbed light into an electrical signal, in the same in-plane on the substrate 110, thereby performing both a display function and a biometric recognition function. The light absorption sensor 300 may be configured to absorb light emitted from at least one of the first, second, or third light emitting elements 210, 220, or 230 and then reflected by a recognition target 40, and convert the absorbed light into an electrical signal. Accordingly, unlike conventional display panels including a sensor formed on the outside of the display panel or formed under the display panel by manufacturing the sensor as a separate module, it may improve performance without increasing the thickness, implementing a slim-type high performance sensor-embedded display panel 1000.

In addition, since the light absorption sensor 300 may use light emitted from the first, second, and/or third light emitting elements 210, 220, and 230, the biometric recognition function may be performed without a separate light source. Therefore, it is not necessary to provide a separate light source outside the display panel, thereby preventing a decrease in the aperture ratio of the display panel due to the area occupied by the light source, and at the same time saving power consumed by the separate light source to improve power consumption.

In addition, as described above, the first, second, and third light emitting elements 210, 220, and 230 and the light absorption sensor 300 may share a common electrode 320, a first common auxiliary layer 340, and a second common auxiliary layer 350, and thus the structure and process may be simplified compared with the case where the first, second, and third light emitting elements 210, 220, and 230 and the light absorption sensor 300 are formed in separate processes.

In addition, as described above, the light absorption sensor 300 further includes an n-type semiconductor layer 360 on the light absorbing layer 330 and/or a p-type semiconductor layer 370 under the light absorbing layer 330, thereby preventing deterioration of electrical characteristics that may occur in a structure in which the common electrode 320, the first common auxiliary layer 340, and the second common auxiliary layer 350 are shared with the first, second, and third light emitting elements 210, 220, and 230 and improving photoelectric conversion efficiency of the light absorption sensor 300.

In addition, as described above, the light absorption sensor 300 may be an organic photoelectric diode including an organic light absorbing layer, and accordingly, it may have a light absorbance that is two or more times higher than that of an inorganic diode such as a silicon photodiode, performing a high-sensitivity biometric detection function with further thinner thickness.

In addition, as described above, since the light absorption sensor 300 may include the light absorbing layer 330 having wavelength selectivity, the sensitivity to light in the red wavelength spectrum, green wavelength spectrum, or blue wavelength spectrum is selectively increased and the color separation characteristics may be improved without mixing of the wavelength spectrum. Accordingly, the sensor-embedded display panel 1000 may additionally implement an anti-spoofing effect in addition to the above-described effects, thereby enhancing the color separation characteristics of the light reflected by the recognition target 40 to further increase details of the shape of the recognition target 40, thereby selectively recognizing the color of the reflected light (e.g., skin color), to further increase the accuracy of the biometric recognition function.

In addition, as described above, since the light absorption sensors 300 may be anywhere in the non-display area UDA, they may be disposed at a desired location of the sensor-embedded display panel 1000 as many as desired. Therefore, for example, by randomly or regularly arranging the light absorption sensor 300 over the entire sensor-embedded display panel 1000, the biometric recognition function may be performed on any position of the screen of an electronic device such as a mobile device and the biometric recognition function may be selectively performed only in a specific location where the biometric recognition function is required.

Hereinafter, another example of the sensor-embedded display panel 1000 according to some example embodiments will be described.

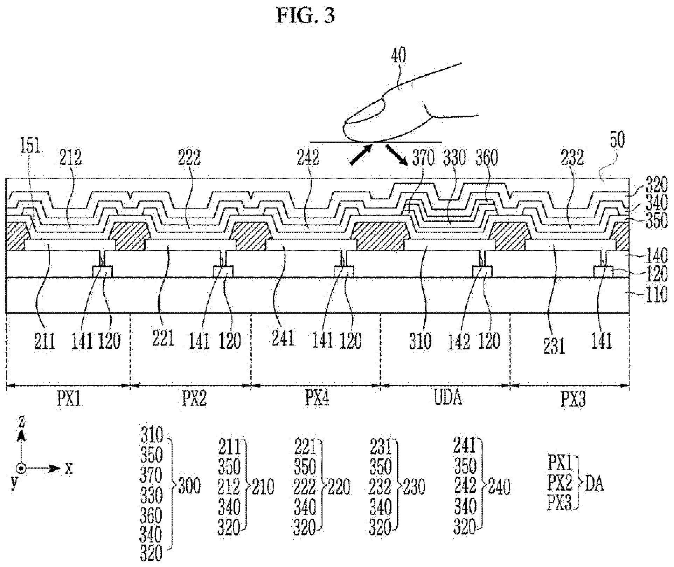

FIG. 3 is a cross-sectional view illustrating another example of a sensor-embedded display panel according to some example embodiments.

Referring to FIG. 3, a sensor-embedded display panel 1000 according to some example embodiments includes a plurality of subpixels PXs displaying different colors, that is, a first subpixel PX1, a second subpixel PX2, and a third subpixel PX3 displaying a first color, a second color, and a third color selected from red, green, and blue, and the first subpixel PX1, the second subpixel PX2, and the third subpixel PX3 include a first light emitting element 210, a second light emitting element 220, and a third light emitting element 230, respectively, like some example embodiments, including the example embodiments shown in at least FIG. 2. Each light emitting element of the first, second, and third light-emitting elements 210, 220, and 230 may be configured to emit light belonging to a visible wavelength spectrum.

However, unlike some example embodiments, including the example embodiments shown in at least FIG. 2, the sensor-embedded display panel 1000 according to some example embodiments may include the fourth light emitting element 240 configured to emit light in an infrared wavelength spectrum. For example, the fourth light emitting element 240 may be included in the fourth subpixel PX4 adjacent to the first subpixel PX1, the second subpixel PX2, and/or the third subpixel PX3, or may be included in a non-display area, UDA. The fourth subpixel PX4 may form one unit pixel UP together with the first subpixel PX1, the second subpixel PX2, and the third subpixel PX3, and the unit pixel UP may be arranged repeatedly along rows and/or columns.

Descriptions of the first subpixel PX1, the second subpixel PX2, the third subpixel PX3, the first light emitting element 210, the second light emitting element 220, and the third light emitting element 230 are the same as described above.

The fourth light emitting element 240 is disposed on the substrate 110 and may be disposed on the same plane as the first, second, and third light emitting elements 210, 220, and 230, and the light absorption sensor 300. The fourth light emitting element 240 may be electrically connected to a separate thin film transistor 120 and driven independently. The fourth light emitting element 240 may have a structure in which the pixel electrode 241, the second common auxiliary layer 350, the light emitting layer 242, the first common auxiliary layer 340, and the common electrode 320 are sequentially stacked. Among them, the common electrode 320, the first common auxiliary layer 340, and the second common auxiliary layer 350 may be shared with the first, second, and third light emitting elements 210, 220, and 230, and the light absorption sensor 300. The light emitting layer 242 may be configured to emit light of an infrared wavelength spectrum, which may have for example a maximum emission wavelength in greater than or equal to about 750 nm, about 750 nm to about 20 µm, about 780 nm to about 20 µm, about 800 nm to about 20 µm, about 750 nm to about 15 µm, about 780 nm to about 15 µm, about 800 nm to about 15 µm, about 750 nm to about 10 µm, about 780 nm to about 10 µm, about 800 nm to about 10µm , about 750 nm to about 5 µm, about 780 nm to about 5 µm, about 800 nm to about 5 µm, about 750 nm to about 3 µm, about 780 nm to about 3 µm, about 800 nm to about 3 µm, about 750 nm to about 2 µm, about 780 nm to about 2 µm, about 800 nm to about 2 µm, about 750 nm to about 1.5 µm, about 780 nm to about 1.5 µm, or about 800 nm to about 1.5 µm.

The light absorption sensor 300 may be configured to absorb light emitted from at least one of the first, second, third, or fourth light emitting elements 210, 220, 230, and 240 and then reflected by a recognition target 40 such as a living body or a tool, and then convert the absorbed light into an electrical signal. For example, the light absorption sensor 300 may be configured to absorb light in an infrared wavelength spectrum emitted from the fourth light emitting element 240 and then reflected by the recognition target 40, and convert the absorbed light into an electrical signal. In this case, the light absorbing layer 330 of the light absorption sensor 300 may include an organic material, an inorganic material, an organic-inorganic material, or any combination thereof configured to selectively absorb light in the infrared wavelength spectrum. For example, the light absorbing layer 330 may include a quantum dot, a quinoid metal complex compound, a polymethine compound, a cyanine compound, a phthalocyanine compound, a merocyanine compound, a naphthalocyanine compound, an immonium compound, a diimmonium compound, a triarylmethane compound, a dipyrromethene compound, an anthraquinone compound, a naphthoquinone, a diquinone compound, a naphthoquinone compound, an anthraquinone compound, a squarylium compound, a rylene compound, a perylene compound, a squaraine compound, a pyrylium compound, a squaraine compound, a thiopyrylium compound, a diketopyrrolopyrrole compound, a boron dipyrromethene compound, a nickel-dithiol complex compound, a croconium compound, a derivative thereof, or any combination thereof, but is not limited thereto.

The sensor-embedded display panel 1000 according to some example embodiments includes the fourth light emitting element 240 configured to emit light in the infrared wavelength spectrum and the light absorption sensor 300 configured to absorb light in the infrared wavelength spectrum. Therefore, in addition to the biometric detection function, the sensitivity of the light absorption sensor 300 may be improved even in a low-illumination environment, and the detection capability of a three-dimensional image may be further increased by widening a dynamic range for detailed division of black and white contrast. Accordingly, the sensing capability of the sensor-embedded display panel 1000 may be further improved. In particular, since light in the infrared wavelength spectrum may have a deeper penetration depth due to its long wavelength characteristics and information located at different distances may be effectively obtained, images or changes in blood vessels such as veins, iris and/or face, etc., in addition to fingerprints may be effectively detected, and the scope of application may be further expanded.

The aforementioned sensor-embedded display panel 1000 may be applied to (e.g., included in) electronic devices such as various display devices. Electronic devices such as display devices may be applied to, for example, mobile phones, video phones, smart phones, mobile phones, smart pads, smart watches, digital cameras, tablet PCs, laptop PCs, notebook computers, computer monitors, wearable computers, televisions, digital broadcasting terminals, e-books, personal digital assistants (PDAs), portable multimedia player (PMP), enterprise digital assistant (EDA), head mounted display (HMD), vehicle navigation, Internet of Things (IoT), Internet of all things (IoE), drones, door locks, safes, automatic teller machines (ATM), security devices, medical devices, or automotive electronic components, but are not limited thereto.

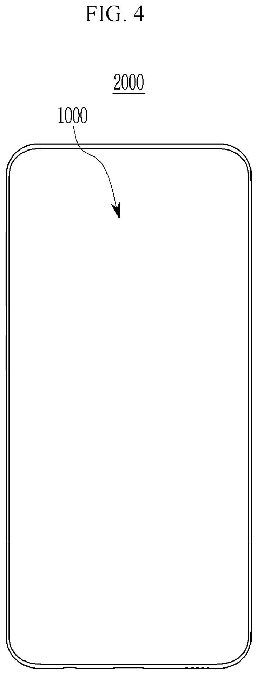

FIG. 4 is a schematic view illustrating an example of a smart phone as an electronic device according to some example embodiments.

Referring to FIG. 4, the electronic device 2000 (which may be a display device) may include the aforementioned sensor-embedded display panel 1000, and the light absorption sensor 300 is disposed in the whole or a part of the sensor-embedded display panel 1000, and thus a biometric recognition function may be performed on any part of the screen, and according to the user's selection, the biometric recognition function may be selectively performed only at a specific location where the biometric recognition function is required.

An example of a method of recognizing the recognition target 40 in an electronic device 2000 such as a display device may include, for example, driving the first, second, and third light emitting elements 210, 220, and 230 of the sensor-embedded display panel 1000 (or the first, second, third, and fourth light emitting elements 210, 220, 230, and 240) and the light absorption sensor 300 to detect the light reflected by the recognition target 40 among the light emitted from the first, second, and third light emitting elements 210, 220, and 230 (or the first, second, third and fourth light emitting element 210, 220, 230, and 240) in the light absorption sensor 300; comparing the image of the recognition target 40 stored in advance with the image of the recognition target 40 detected by the light absorption sensor 300; and judging the consistency of the compared images and if they match according to the determination that recognition of the recognition target 40 is complete, turning off the light absorption sensor 300, permitting user's access to the display device, and driving the sensor-embedded display panel 1000 to display an image.

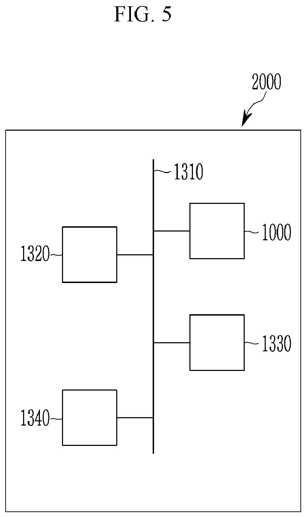

FIG. 5 is a schematic view illustrating an example of a configuration view of an electronic device according to some example embodiments.

Referring to FIG. 5, in addition to the aforementioned constituent elements (e.g., the sensor-embedded display panel 1000), the electronic device 2000 may further include a bus 1310, a processor 1320, a memory 1330, and at least one additional device 1340. Information of the aforementioned sensor-embedded display panel 1000, processor 1320, memory 1330, and at least one additional device 1340 may be transmitted to each other through the bus 1310.

The processor 1320 may include one or more processing circuitry such as a hardware including logic circuits; a hardware/software combination such as processor-implemented software; or any combination thereof. For example, the processing circuitry may be a central processing unit (CPU), an arithmetic logic unit (ALU), a digital signal processor, a microcomputer, a field programmable gate array (FPGA), System-on-Chip (SoC), a programmable logic unit, a microprocessor, an application-specific integrated circuit (ASIC), and the like. As an example, the processing circuitry may include a non-transitory computer readable storage device. The processor 1320 may control, for example, a display operation of the sensor-embedded display panel 1000 or a sensor operation of the light absorption sensor 300.

The memory 1330 may store an instruction program, and the processor 1320 may perform a function related to the sensor-embedded display panel 1000 by executing the stored instruction program.

The one or more additional devices 1340 may be one or more communication interfaces (e.g., wireless communication interfaces, wired interfaces), user interfaces (e.g., keyboard, mouse, buttons, etc.), power supply and/or power supply interfaces, or any combination thereof.

The units and/or modules described herein may be implemented using hardware constituent elements and software constituent elements. For example, the hardware constituent elements may include microphones, amplifiers, band pass filters, audio-to-digital converters, and/or processing devices. The processing device may be implemented using one or more hardware devices configured to perform and/or execute program code by performing arithmetic, logic, and input/output operations. The processing device may include a processor, a controller and an arithmetic logic unit, a digital signal processor, a microcomputer, a field programmable array, a programmable logic unit, a microprocessor, or any other device capable of responding to and executing instructions. The processing device may access, store, operate, process, and generate data in response to execution of an operating system (OS) and one or more software running on the operating system.

The software may include a computer program, a code, an instruction, or any combination thereof, and may transform a processing device for a special purpose by instructing and/or configuring the processing device independently or collectively to operate as desired. The software and data may be implemented permanently or temporarily as signal waves capable of providing or interpreting instructions or data to machines, parts, physical or virtual equipment, computer storage media or devices, or processing devices. The software may also be distributed over networked computer systems so that the software may be stored and executed in a distributed manner. The software and data may be stored by one or more non-transitory computer readable storage devices.

The method according to the foregoing example embodiments may be recorded in a non-transitory computer readable storage device including program instructions for implementing various operations of the aforementioned example embodiments. The storage device may also include program instructions, data files, data structures, and the like alone or in combination. The program instructions recorded in the storage device may be specially designed for some example embodiments or may be known to those skilled in computer software and available for use. Examples of non-transitory computer-readable storage devices may include magnetic media such as hard disks, floppy disks, and magnetic tapes; optical media such as CD-ROM discs, DVDs and/or blue-ray discs; magneto-optical media such as optical disks; and a hardware device configured to store and execute program instructions such as ROM, RAM, flash memory, and the like. The aforementioned device may be configured to operate as one or more software modules to perform the operations of the aforementioned example embodiments.

Hereinafter, some example embodiments are illustrated in more detail with reference to examples. However, the present scope of the inventive concepts are not limited to these examples.

### Manufacture of Light Absorption Sensor

### Example 1

Al (10 nm), ITO (100 nm), and Al (8 nm) are sequentially deposited on the glass substrate to form a lower electrode of an AI/ITO/AI structure. Subsequently, N,N'-bis(3-methylphenyl)-N,N'-diphenyl-[1,1-biphenyl]-4,4'-diamine is deposited on the lower electrode to form a hole auxiliary layer (HOMO: 5.3 eV to 5.6 eV, LUMO: 2.0 eV to 2.3 eV). Then, a p-type semiconductor represented by Compound A (HOMO: 5.65 eV, LUMO: 3.68 eV) and an n-type semiconductor represented by fullerene (C60) (HOMO: 6.40 eV, LUMO: 4.23 eV) are co-deposited in a 1:1 volume ratio (thickness ratio) on the hole auxiliary layer to form a 50 nm-thick light absorbing layer (λₘₐₓ = 550 nm). Then, C60 is deposited on the light absorbing layer to form a 5 nm-thick n-type semiconductor layer, and 4,7-diphenyl-1,10-phenanthroline is deposited thereon to form an electron auxiliary layer (HOMO: 6.1 eV to 6.4 eV, LUMO: 2.9 eV to 3.2 eV). Then, magnesium and silver are deposited on the electron auxiliary layer to form a Mg:Ag upper electrode to manufacture a light absorption sensor.

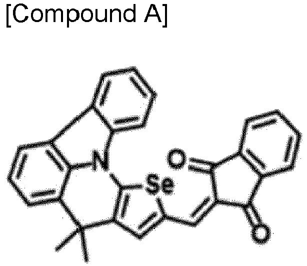

### Example 2

A light absorption sensor is manufactured in the same manner as in Example 1, except that a 5 nm-thick p-type semiconductor layer is additionally formed by depositing a p-type semiconductor represented by Compound A on the whole auxiliary layer before forming a light absorbing layer.

### Comparative Example 1

A light absorption sensor is manufactured in the same manner as in Example 1 except that the n-type semiconductor layer is not formed.

### Evaluation

The photoelectric conversion efficiency of the light absorption sensors according to Examples and Comparative Examples is evaluated.

The photoelectric conversion efficiency is evaluated from the external quantum efficiency (EQE), and the external quantum efficiency (EQE) may be evaluated from the external quantum efficiency (EQE) at the peak absorption wavelength (λₘₐₓ), and is evaluated using IPCE (Incident Photon to Current Efficiency) method in a wavelength region of 400 nm to 700 nm.

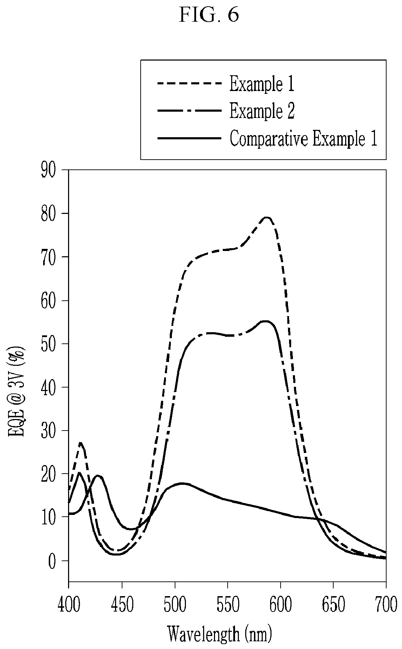

The results are shown in FIG. 6.

FIG. 6 is a graph showing external quantum efficiency (EQE) according to the wavelength of the light absorption sensor according to Examples 1 and 2 and Comparative Example 1.

Referring to FIG. 6, the light absorption sensors according to Examples 1 and 2 exhibit improved photoelectric conversion efficiency in the green wavelength spectrum compared with the light absorption sensors according to Comparative Example 1.

While the inventive concepts have been described in connection with what is presently considered to be practical example embodiments, it is to be understood that the inventive concepts are not limited to such example embodiments. On the contrary, the inventive concepts are intended to cover various modifications and equivalent arrangements included within the scope of the appended claims.

## Claims

1. A sensor-embedded display panel, comprising:
a substrate;
first, second, and third light emitting elements on the substrate, the first, second, and third light emitting elements including separate, respective light emitting layers; and
a light absorption sensor on the substrate, the light absorption sensor including a light absorbing layer extending in parallel with the separate, respective light emitting layers along a surface direction of the substrate,
wherein the first, second, and third light emitting elements and the light absorption sensor include
a first common auxiliary layer extending continuously on the separate, respective light emitting layers and the light absorbing layer, and
a common electrode on the first common auxiliary layer, the common electrode being configured to apply a common voltage to the first, second, and third light emitting elements and the light absorption sensor, and
wherein the light absorption sensor includes an n-type semiconductor layer between the light absorbing layer and the first common auxiliary layer, the n-type semiconductor layer including a first n-type semiconductor.

2. The sensor-embedded display panel of claim 1, wherein the light absorption sensor is configured to
absorb light emitted from at least one of the first, second, or third light emitting elements and then reflected by a recognition target, and
convert the absorbed light into an electrical signal.

3. The sensor-embedded display panel of claims 1 or 2, wherein the light absorbing layer is configured to absorb light in a red wavelength spectrum, a green wavelength spectrum, a blue wavelength spectrum, or any combination thereof.

4. The sensor-embedded display panel of any of claims 1-3, wherein the light absorbing layer includes a first p-type semiconductor.

5. The sensor-embedded display panel of claim 4, wherein
the light absorbing layer further includes a second n-type semiconductor, and
the second n-type semiconductor of the light absorbing layer is
a same n-type semiconductor as the first n-type semiconductor of the n-type semiconductor layer, or
a different n-type semiconductor from the first n-type semiconductor of the n-type semiconductor layer;
preferably wherein
the light absorption sensor further includes a p-type semiconductor layer under the light absorbing layer, the p-type semiconductor layer including a second p-type semiconductor, and
the second p-type semiconductor of the p-type semiconductor layer is
a same p-type semiconductor as the first p-type semiconductor of the light absorbing layer, or
a different p-type semiconductor from the first p-type semiconductor of the light absorbing layer.

6. The sensor-embedded display panel of any of claims 1-5, wherein the n-type semiconductor layer has a LUMO energy level of 3.3 eV to 5.5 eV; and/or
wherein a LUMO energy level of the first common auxiliary layer is between a LUMO energy level of each light-emitting layer of the separate, respective light emitting layers and a work function of the common electrode; and/or
wherein a LUMO energy level of the first common auxiliary layer is shallower than a LUMO energy level of the light absorbing layer and a work function of the common electrode, respectively; and/or
wherein the first, second, and third light emitting elements and the light absorption sensor further include a second common auxiliary layer extending continuously under the separate, respective light emitting layers and the light absorbing layer.

7. The sensor-embedded display panel of any of claims 1-6, wherein
each light emitting element of the first, second, and third light emitting elements is independently configured to emit one light of a red wavelength spectrum, a green wavelength spectrum, a blue wavelength spectrum, or any combination thereof, and
the light absorbing layer is configured to absorb light of a same wavelength spectrum as the light emitted from at least one light emitting element of the first, second, and third light emitting elements.

8. The sensor-embedded display panel of any of claims 1-7, wherein
the sensor-embedded display panel comprises
a display area configured to display a color, and
a non-display area excluding the display area, and
the light absorption sensor is in the non-display area;
preferably wherein
the display area includes
a first subpixel configured to emit light in a red wavelength spectrum, the first subpixel including the first light emitting element,
a second subpixel configured to emit light in a green wavelength spectrum, the second subpixel including the second light emitting element, and
a third subpixel configured to emit light in a blue wavelength spectrum, the third subpixel including the third light emitting element, and
the light absorption sensor is between at least two of the first subpixel, the second subpixel, or the third subpixel.

9. The sensor-embedded display panel of any of claims 1-8, wherein
each light emitting element of the first, second, and third light emitting elements is configured to emit light belonging to a visible wavelength spectrum, and
the sensor-embedded display panel further comprises a fourth light emitting element configured to emit light in an infrared wavelength spectrum;
preferably wherein the light absorption sensor is configured to absorb light of the infrared wavelength spectrum.

10. The sensor-embedded display panel of any of claims 1-9, wherein the light absorbing layer comprises an organic material; and/or
wherein the separate, respective light emitting layers each include an organic light emitter, a quantum dot, perovskite, or any combination thereof.

11. A sensor-embedded display panel, comprising:
a display area configured to display a color; and
a non-display area excluding the display area,
wherein the display area includes
a first subpixel configured to display a first color, the first subpixel including a first light emitting element,
a second subpixel configured to display a second color, the second subpixel including a second light emitting element, and
a third subpixel configured to display a third color, the third subpixel including a third light emitting element,
wherein the non-display area includes a light absorption sensor between at least two of the first subpixel, the second subpixel, or the third subpixel,
wherein the first light emitting element, the second light emitting element, the third light emitting element, and the light absorption sensor share a common electrode configured to apply a common voltage to the first light emitting element, the second light emitting element, the third light emitting element, and the light absorption sensor, and
wherein the light absorption sensor comprises
a light absorbing layer including a first p-type semiconductor and a first n-type semiconductor forming a pn junction and configured to absorb light reflected by a recognition target and to convert the absorbed light into an electrical signal, and
an n-type semiconductor layer between the light absorbing layer and the common electrode and including a second n-type semiconductor, the second n-type semiconductor being
a same n-type semiconductor as the first n-type semiconductor,
or
a different n-type semiconductor from the first n-type semiconductor.

12. The sensor-embedded display panel of claim 11, wherein
the first light emitting element, the second light emitting element, the third light emitting element, and the light absorption sensor share a first common auxiliary layer under the common electrode, and
a LUMO energy level of the first common auxiliary layer is shallower than a LUMO energy level of the light absorbing layer and a work function of the common electrode, respectively.

13. The sensor-embedded display panel of claim 12, wherein the first light emitting element, the second light emitting element, the third light emitting element, and the light absorption sensor share a second common auxiliary layer facing the first common auxiliary layer;
preferably wherein the light absorption sensor comprises a p-type semiconductor layer between the light absorbing layer and the second common auxiliary layer and including a second p-type semiconductor, the second p-type semiconductor being
a same p-type semiconductor as the first p-type semiconductor, or
a different p-type semiconductor from the first p-type semiconductor.

14. The sensor-embedded display panel of claims 12 or 13, further comprising:
a fourth subpixel adjacent to at least one of the first subpixel, the second subpixel, or the third subpixel,
wherein the fourth subpixel includes a fourth light emitting element configured to emit light in an infrared wavelength spectrum.

15. A display device comprising the sensor-embedded display panel of any of claims 1-14.
